(19) Europäisches Patentamt
European Patent Office
Office européen des brevets

(11) Veröffentlichungsnummer: **0 276 709**
**A2**

(12) **EUROPÄISCHE PATENTANMELDUNG**

(21) Anmeldenummer: **88100572.2**

(22) Anmeldetag: **16.01.88**

(51) Int. Cl.⁴: **C08F 220/42**, C08F 220/36, C08F 222/22, G03F 7/10, //(C08F220/42,220:36,220:04), (C08F220/36,220:42,220:04), (C08F222/22,220:42,220:04)

(30) Priorität: **21.01.87 DE 3701569**

(43) Veröffentlichungstag der Anmeldung: **03.08.88 Patentblatt 88/31**

(84) Benannte Vertragsstaaten: **AT BE CH DE FR GB IT LI NL**

(71) Anmelder: **BASF Aktiengesellschaft**
**Carl-Bosch-Strasse 38**
**D-6700 Ludwigshafen(DE)**

(72) Erfinder: **Schwalm, Reinhold, Dr.**
**Am Huettenwingert 53**
**D-6706 Wachenheim(DE)**
Erfinder: **Binder, Horst**
**Haendelstrasse 3-5**
**D-6840 Lampertheim(DE)**

(54) **Copolymerisate mit o-Nitrocarbinolestergruppierungen, deren Verwendung sowie Verfahren zur Herstellung von Halbleiterbauelementen.**

(57) Die Erfindung betrifft Copolymerisate mit o-Nitrocarbinolester-gruppierungen und ein Verfahren zur Herstellung von Halbleiterbauelementen unter Verwendung dieser Copolymerisate.

Die erfindungsgemäßen Copolymerisate enthalten 5 bis 50 Mol.% Monomere mit o-Nitrocarbinolestergruppierungen, 94 bis 30 Mol.% Methacrylnitril, 1 bis 20 Mol.% einer olefinisch ungesättigten copolymerisierbaren Carbonsäure sowie 0 bis 30 Mol.% anderer copolymerisierbarer Monomerer einpolymerisiert.

Sie eignen sich zur Herstellung von Halbleiterbauelementen.

EP 0 276 709 A2

## Copolymerisate mit o-Nitrocarbinolestergruppierungen, deren Verwendung sowie Verfahren zur Herstellung von Halbleiterbaulelementen

Die Erfindung betrifft Copolymerisate mit o-Nitrocarbinolestergruppierungen sowie deren Verwendung als lichtempfindliche Beschichtungsmaterialien für Photoresiste und ein Verfahren zur Herstellung von Halbleiterbauelementen, bei dem man ein lichtempfindliches Material mit UV-Licht im Bereich von 190 nm bildmäßig bestrahlt, das Muster entwickelt und mit Hilfe eines Plasma in das unterliegende Substrat transferiert und die Herstellung des Bauelementes zu Ende führt.

Positiv arbeitende Acrylatresiste für die Anwendung in fotolithografischen Verfahren zur Herstellung von Halbleiterbauelementen sind bekannt. Bei diesen Materialien handelt es sich überwiegend um Poly-(methylmethacrylat)-Derivate, die nach der Belichtung in organischen Lösungsmitteln löslich werden, in denen sie vor der Belichtung unlöslich waren. Eine Zusammenstellung von Acrylatresisten gibt W. Moreau. "State of the art of acrylate resists: an overview of polymer structure and lighographic performance" in Optical Engineering, Vol. 22(2), p. 181-184 (1983).

Lichtempfindliche Beschichtungsmaterialien die o-Nitrocarbinolestergruppierungen enthalten und mit alkalischen Lösungsmitteln ausgewaschen werden können sind z.B. in DE-A-2 150 691 und DE-A-2 922 746 beschrieben.

Diese bekannten Beschichtungsmaterialien, die sich für die Herstellung von Resistschichten eignen, sind zwar gegenüber starken und aggressiven Säuren und Laugen, wie sie beispielweise in Ätzbädern zur Anwendung gelangen können, im allgemeinen hinreichend beständig, jedoch in fluor-und chlorhaltigen Plasmen, wie sie zur Ätzung bei der Halbleiterbauelementeherstellung vorkommen, ist die Stabiltät begrenzt und weiter verbesserungswürdig. Außerdem ist die Temperaturstabilität dieser Beschichtungsmaterialien nach dem Belichten und Entwickeln für diese Anwendungszwecke unzureichend, da die Festigkeit der hiermit hergestellten Resistschichten overhalb 50° stark abnimmt.

Die Plasmastabilität von Polymethylmethacrylat (= PMMA) und Derivaten ist etwa 2 bis 5 mal geringer als die kommerzieller Novolak-Resiste (L. Pederson in J.Electrochem.Soc. 129, 206 (1982); K. Harada, J.Appl.Pol. Sci. 26, 3395 (1981); K. Harada, J.Electrochem. Soc. 128, 491 (1981)). Erhöhte Plasmastabilität von PMMA-Derivaten wurden durch Einführung von Phenylringen in die Esterseitengruppen oder Cyanogruppen erreicht (I.N. Helbert and M.A. Schmidt in Polymer Materials for Electronic Applications, Am.Chem.Soc.Symp.Ser. 184, E.D. Feit and C. Wilkins. Jr. Es., Washington, DC, 1982, pp. 61-72 und J.N. Helbert, M.A. Schmidt, C. Malkiewicz, E. Wallace, Jr., and C.U. Pittman, Jr., in Polymers in Electronics, Am.Chem.Soc.Symp.Ser. 242, T. Davidson, Ed., Washington, DC, 1984, pp. 91-100).

Diese bekannten Systeme zeigen zwar verbesserte Plasmastabilität, sind jedoch nur in organischen Lösungsmitteln auswaschbar.

In US-A 4 389 482 sind Copolymere aus Methacrylnitril und Methacrylsäure beschrieben, die verbesserte Ätzstabilität in $CF_4$-Plasmen gegenüber PMMA zeigen und mit wäßrigem Ethanol ausgewaschen werden können, sie benötigen jedoch einen weiteren Ausbackschritt bei Temperaturen über 140°C vor der Plasmabehandlung.

Aufgabe der vorliegenden Erfindung ist es, positiv arbeitende Acrylatresiste zur Verfügung zu stellen, die insbesondere die Herstellung von Resistmustern gestatten, hohe thermische Stabilität, Resistenz gegenüber Fluor-und Chlor-Plasmen besitzen und nach bildmäßiger Belichtung mit tiefem UV-Licht ($\lambda$ = 190 nm bis 300 nm) mit Wasser bzw. wäßrig-alkalischen Lösungsmitteln auswaschbar sind.

Es wurde nun gefunden, daß diese Aufgabe gelöst wird, wenn man von einem Copolymeren ausgeht, welches aus einem o-Nitrocarbinolester einer ungesättigten Carbonsäure, Methacrylnitril und gegebenenfalls weiteren Comonomeren hergestellt wurde, und das nach der Belichtung mit einem wäßrig-alkalischen Lösungsmittel ausgewaschen werden kann. Um hohe thermische Stabilität zu erreichen, sind die Monomeren zweckmäßigerweise so ausgewählt, daß die Glastemperatur des resultierenden Copolymeren deutlich über 100°C liegt. Weiterhin ist es von Vorteil, wenn man die Acrylatmonomeren so wählt, daß die $\alpha$-Position alkyliert ist, um eine Vernetzungsreaktion während der Belichtung über $\alpha$-Wasserstoffabstraktion zu verhindern.

Gegenstand der vorliegenden Erfindung sind daher Copolymerisate, die einpolymerisiert enthalten

(a) 5 bis 50 Mol.% mindestens einer Verbindung der allgemeinen Formel (I)

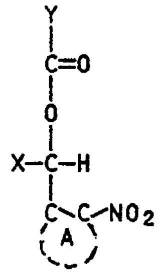

(I)

worin

A für ein aromatisches oder heteroaromatisches, gegebenenfalls substituiertes Ringsystem mit 5 bis 14 Ringgliedern,

X für Wasserstoff, einen Alkylrest mit 1 bis 8 Kohlenstoffatomen, einen gegebenenfalls substituierten Aryl- oder Aralkylrest und

Y für einen ethylenisch ungesättigten Rest mit 2 bis 6 Kohlenstoffatomen stehen,

b) 94 bis 30 Mol.% Methacrylnitril

c) 1 bis 20 Mol.% mindestens einer olefinisch ungesättigten copolymerisierbaren Carbonsäure mit 3 bis 6 Kohlenstoffatomen,

d) 0 bis 30 Mol.% einer oder mehrerer weiterer von (a), (b) und (c) verschiedener olefinisch ungesättigter, copolymerisierbarer organischer Verbindungen, deren Homopolymerisate im Wellenlängenbereich zwischen 250 und 400 nm transparent sind, mit der Maßgabe, daß die Summe der unter a) bis d) genannten Prozentzahlen 100 ist.

Der Rest Y in der allgemeinen Formel (I) steht insbesondere für einen der Reste

$-CH=CH_2$ , 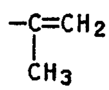 , $-CH=CH-COOH$ , $-CCl=CCl-COOH$ , 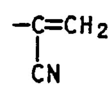 ,

$-CH=CHCH_3$ , 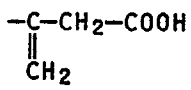 , 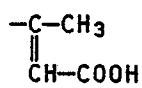 , 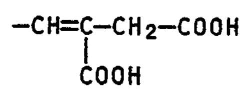 oder

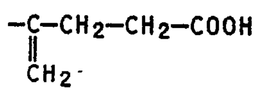 .

Bevorzugt ist außerdem, daß in der allgemeinen Formel (I) der Rest A für Phenyl, der Rest X für Methyl und der Rest Y für eine

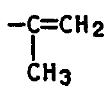

Gruppe steht und als Komponente (c) Methacrylsäure einpolymerisiert ist.

Gegenstand der Erfindung ist insbesondere auch ein Verfahren zur Herstellung von Halbleiterbauelementen, unter Verwendung der erfindungsgemäßen Copolymerisate, wobei das Copolymerisat als lichtempfindlicher Resist auf einem Substrat aufgebracht und bildmäßig mit kurzwelligem UV-Licht belichtet wird und anschließend die belichteten Bereiche mit wäßrig-alkalischen Lösungsmitteln ausgewaschen werden. Aufgrund seiner wesentlich verbesserten Plasmastabilität kann das erzeugte Reliefmuster anschließend mittels fluor-oder chlorhaltiger Plasmen in das Substrat übertragen und danach die Herstellung des Bauelementes zu Ende gebracht werden.

Die erfindungsgemäßen Copolymerisate können auch als lichtempfindliche Beschichtungsmaterialien, zur Herstellung von Trockenresisten und als Photoätzgrund verwendet werden.

Die lichtempfindlichen Copolymerisate können nach verschiedenen bekannten Synthesemethoden hergestellt werden, insbesondere durch radikalische Copolymerisation der Monomeren (a) bis (d). Auch durch Umesterungsreaktionen lassen sich die aromatischen o-Nitrocarbinolgruppierungen einführen, z.B. in Copolymere aus ungesättigten Carbonsäuren und Methacrylnitril.

Zu den das erfindungsgemäße Copolymerisat aufbauenden Komponenten ist im einzelnen folgendes auszuführen.

a) Als o-Nitrocarbinolestermonomere der allgemeinen Formel (I)

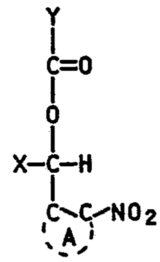
(I)

worin A für ein aromatisches oder heteroaromatisches, gegebenenfalls substituiertes Ringsystem mit 5 bis 14 Ringgliedern, X für Wasserstoff, einen Alkylrest mit 1 bis 8 Kohlenstoffatomen, einen gegebenenfalls substituierten Aryl-oder Aralkylrest und Y für einen ethylenisch ungesättigten Rest mit 2 bis 6 Kohlenstoffatomen stehen,
kommen beispielsweise solche in Frage, in denen der Rest Y in der allgemeinen Formel (I) für einen der Reste

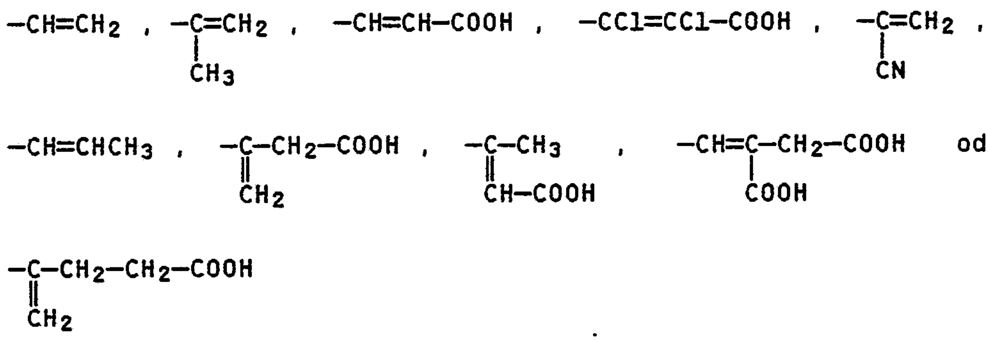
oder

steht.

Dabei werden unter aromatischen Ringsystem A insbesondere Benzol und substituierte Benzole verstanden. Der Benzolring kann ein-oder mehrfach substituiert sein, beispielsweise durch $C_1$-bis $C_8$-Alkyl, insbesondere Methyl, durch $C_1$-bis $C_6$-Alkoxi, insbesondere Methoxi, durch Halogen, wie Chlor oder Brom, durch Nitro-oder Amino-, Monomethylamino-, Dimethylamino-, Nitril-sowie durch Sulfogruppen. Es kommen auch entsprechend substituierte und unsubstituierte mehrkernige aromatische Ringsysteme, wie Naphthalin, Anthracen, Anthrachinon, Phenanthren oder deren entsprechend substituierten Derivate in Betracht. Als heteroaromatisches Ringsystem A ist des Pyridinrest bevorzugt. Der Rest X ist insbesondere Wasserstoff, ein Methyl-oder Ethylrest oder ein gegebenenfalls substituierter Phenylrest.

Als den o-Nitrocarbinolestergruppierungen zugrunde liegende aromatische oder heteroaromatische o-Nitrocarbinole haben sich beispielsweise die folgenden Gruppierungen besonders bewährt: o-Nitrobenzyl-, 6-Nitroveratryl-, 2-Nitro-4-aminobenzyl-, 2-Nitro-4-dimethylaminobenzyl-, 2-Nitro-4-methylaminobenzyl-, 2-Nitro-5-dimethylaminobenzyl-, 2-Nitro-5-aminobenzyl-, 2-Nitro-4,6-dimethoxibenzyl-, 2,4-Dinitrobenzyl-, 3-Methyl-2,4-dinitrobenzyl-, 2-Nitro-4-methylbenzyl-, 2,4,6-Trinitrobenzylalkohol sowie 2-Nitrobenzhydrol, 2,2'-Dinitrobenzhydrol, 2,4-Dinitrobenzyhydrol oder 2,2',4,4'-Tetranitrobenzhydrol. Ebenso geeignet sind beispielsweise 2-Nitro-3-hydroximethylnaphthalin, 1-Nitro-2-hydroximethylnaphthalin oder 1-Nitro-2-hydroximethylanthrachinon.

Beispiele für besonders bevorzugte aromatische oder heteroaromatische o-Nitrocarbinole, die den o-Nitrocarbinolestergruppierungen der allgemeinen Formel (I) zugrundeliegen, sind o-Nitrobenzylalkohol, 2-Nitro-6-chlor-benzylalkohol, 2-Nitro-4-cyanobenzylalkohol, 2-Nitro-4,5-dimethoxybenzylalkohol, $\alpha$-Methyl-o-nitrobenzylalkohol, $\alpha$-phenyl-o-nitrobenzylalkohol, $\alpha$-(o-Nitrophenyl)-o-nitrobenzylalkohol und 2-Nitro-3-hydroxymethylpyridin.

Den erfindungsgemäßen Copolymerisaten liegen, wie oben bereits ausgeführt o-Nitrocarbinolester von olefinisch ungesättigten Carbonsäuren als Monomere zugrunde, wobei als ethylenisch ungesättigte Mono-oder Dicarbonsäuren beispielsweise Acrylsäure, Methacrylsäure, Maleinsäure, Dichlormaleinsäure, Fumarsäure, Crotonsäure, Itaconsäure sowie Methylenglutarsäure verwendet können. Bevorzugt sind $\alpha$-alkylsubstituierte Carbonsäuren, insbesondere Methacrylsäure.

Die o-Nitrocarbinolester von olefinisch ungesättigten Carbonsäuren können nach bekannten Methoden

der organischen Chemie, wie z.B. Umsetzung der Säurechloride mit o-Nitrocarbinolen oder durch direkte säurekatalyiserte Veresterung hergestellt werden.

Besonders bevorzugte o-Nitrocarbinolestermonomere sind o-Nitrobenzylacrylat, o-Nitrobenzyl-methacrylat, o-Nitro-α-methyl-benzyl-(meth)acrylat und 2-Nitro-6-chlor-α-methyl-benzyl-(meth)acrylat.

Die erfindungsgemäßen Copolymerisate enthalten die o-Nitrocarbinolestermonomeren (a) in einer Menge von 5 bis 50, vorzugsweise 10 bis 30 Mol.% einpolymerisiert.

b) Als Comonomere (b) enthalten die erfindungsgemäßen Copolymerisate Methacrylnitril, das in einer Menge von 94 bis 30, vorzugsweise 89 bis 50 Mol.% im erfindungsgemäßen Copolymerisat einpolymerisiert ist.

c) Als Comonomere (c) enthalten die erfindungsgemäßen Copolymerisate mindestens eine olefinisch ungesättigte copolymerisierbare Carbonsäure mit 3 bis 6 Kohlenstoffatomen einpolymerisiert, wie z.B. Acrylsäure, Methacrylsäure, Maleinsäure oder deren Gemische. Bevorzugt ist Methacrylsäure.

Die Monomeren (c) sind in Mengen von 1 bis 20 Mol.% im erfindungsgemäßen Copolymerisat einpolymerisiert.

d) Die erfindungsgemäßen Copolymerisate können zur Verbesserung der Löslichkeit in wäßrig-alkalischen Lösungsmitteln oder zur Einstellung anderer Eigenschaften, wie erhöhte thermische Beständigkeit, noch eine oder mehrere von (a), (b) und (c) verschiedene olefinisch ungesättigte, copolymerisierbare organische Verbindungen, deren Homopolymerisate im Wellenlängenbereich zwischen 250 und 400 nm transparent sind, einpolymerisiert enthalten.

Als derartige Comonomere sind beispielsweise geeignet, ethylenisch ungesättigte Nitrile, wie Acrylnitril, Malo-dinitril, Fumaro-dinitril und/oder Crotono-nitril, Hydroxyalkyl-(meth)acrylate, (un)-substituierte N-(Meth)-acrylamide, andere ethylenisch ungesättige Verbindungen, wie Ethylen, Diene, wie Isopren, Butadien, Ester der bereits genannten olefinisch ungesättigten Carbonsäuren, wie Ester der Acryl-und insbesondere Methacrylsäure mit $C_1$-bis $C_8$-Alkoholen sowie Gemische dieser Monomeren, vorzugsweise Methylmethacrylat.

Die Monomeren (d) können in Mengen von 0 bis 30, vorzugsweise 0 bis 20 Mol.% im erfindungsgemäßen Copolymerisat einpolymerisiert sein.

Die Summe der unter (a) bis (d) genannten Molprozentzahlen in den erfindungsgemäßen Copolymeren ist 100.

Beispiele für besonders bevorzugte erfindungsgemäße Copolymerisate sind solche aus o-Nitro-α-methyl-benzylmethacrylat, Methacrylnitril und Methacrylsäure; o-Nitro-benzylmethacrylat, Methacrylnitril und Methacrylsäure; 2-Nitro-6-chlor-α-methylbenzylacrylat, Methacrylnitril und Methacrylsäure; o-Nitro-α-methylbenzylmethacrylat, Methacrylnitril, Methacrylsäure und Hydroxyethylmethacrylat.

Die erfindungsgemäßen Copolymerisate lassen sich nach verschiedenen bekannten Polymerisationsmethoden aus den jeweiligen Monomeren herstellen. Die Monomeren werden dabei bevorzugt so gewählt, daß die Glastemperatur des resultierenden Copolymeren oberhalb 100°C liegt. Die Monomeren können dazu beispielsweise in einem geeigneten Lösungsmittel, wie Ethylacetat, Toluol, Aceton, zusammen mit einem Polymerisationsinitiator, wie beispielsweise Benzoylperoxid oder Azo-isobutyronitril, bei Temperaturen im Bereich von 60 bis 120°C für mehrere Stunden erhitzt werden. Die Reaktion wird dabei zweckmäßigerweise so geführt, daß der Umsatz nicht wesentlich mehr als 50 % beträgt, um eine möglichst enge Molekulargewichtsverteilung zu erhalten.

Die Molekulargewichte können durch die Polymerisationsbedingungen, wie Reaktionstemperatur, Initiator und Initiatorkonzentration, sowie Lösungsmittel und Monomerkonzentration bestimmt werden. Initiatorkonzentrationen zwischen 0,1 Mol.% und 5 Mol.% und Monomerkonzentrationen zwischen 3 % und 50 % sind bevorzugt. Das Molekulargwicht und die Molekulargewichtsverteilung haben einen großen Einfluß auf die Löslichkeit im jeweiligen Entwickler. Je niedriger das Molekulargewicht und je enger die Molekulargewichtsverteilung, desto besser und einheitlicher ist die Entwickelbarkeit.

Die erhaltenen Polymeren können zweckmäßigerweise fraktioniert werden, wobei die hochmolekularen Fraktionen, die schlechte Lösungseigenschaften zeigen und die niedermolekularen Fraktionen, die zu einem erhöhten Abtrag der unbelichteten Bereiche führen, verworfen werden. Die Molekulargewichte der bevorzugt verwendeten Fraktionen liegen im Bereich von 20.000 bis 200.000 und enger Molekulargewichtsverteilung, bevorzugt $M_w/M_n < 3$.

Die Verwendung der erfindungsgemäßen Copolymerisate ist nicht auf die Anwendung als Photoresist für die Herstellung von Halbleiterbauelementen beschränkt, sondern sie können auch in lichtempfindlichen Beschichtungsmaterialien, wie Trockenresisten und Druckplatten verwendet werden. Dazu können noch Zusätze wie Farbstoffe, Pigmente, Sensibilisatoren und andere Zusätze den lichtempfindlichen Materialien zugegeben werden.

Bei der Durchführung des Verfahrens zur Herstellung von Halbleiterbauelementen wird das lichtempfindliche Polymer zweckmäßigerweise in einem geeigneten Lösungsmittel (z.B. Dimethylformamid, Diethylenglykoldimethylether) gelöst, die Lösung filtriert, und mit Hilfe der Schleudertechnik wird eine Schicht zwischen 0,5 und 1,5 µm auf ein Halbleitersubstrat (z.B. einen oxidierten Siliciumwafer) aufgebracht. Nach dem Ausheizen der Schicht bei einer Temperatur zwischen 100 und 160°C wird der lichtempfindliche Resist bildmäßig strukturiert, indem die Schicht durch eine direkt aufliegende Maske mit Licht im Wellenlängenbereich von 190 nm bis 300 nm, bevorzugt 248 nm, belichtet und mit wäßrig-alkalischen Lösungsmitteln entwickeln wird. Beispielsweise wird der belichtete Wafer in eine alkalische LÖsung z.B. 3 %ige wäßrige Triethanolamin-, 1 %ige Natriumhydrogencarbonat-oder 0,2 %ige Tetramethylammoniumhydroxid-Lösung, eingetaucht. Typische Entwicklungszeiten liegen im Bereich zwischen 1 und 10 Minuten, vorzugsweise 1 bis 2 Minuten, wobei die Entwicklungszeit nur wenig über der erforderlichen Mindestzeit liegen und der Abtrag der unbelichteten Bereiche weniger als 10 % betragen soll. Danach wird das erzeugte Reliefmuster in einem handelsüblichen Parallelplattenreaktor im Schwefelhexafluorid-oder Tetrafluormethan-Sauerstoffplasma in die darunterliegende Silizium-oder Siliziumdioxidschicht übertragen.

Danach wird der Resist entfernt und das Substrat, z.B. der Siliziumwafer den weiteren bekannten Verfahrensschritten, wie z.B. Dotierung bzw. Metallisierung, zur Herstellung des gewünschten Bauelements unterzogen.

Novolak-Positivresists weisen zwar eine höhere Ätzbeständigkeit auf, sind jedoch für die Belichtung im DUV-Bereich ($\lambda < 300$ nm) im relevanten Schichtdickenbereich > 0,5 µm ungeeignet, da die Novolak-Matrix im DUV-Bereich zu stark absorbiert.

Die erfindungsgemäßen methacrylnitrilhaltigen Copolymeren lassen sich dagegen im DUV-Bereich ideal belichten und zeichnen sich gegenüber dem üblichen Polymethylmethacrylat DUV-Resist besonders durch erhöhte Stabilität in fluor-und chlorhaltigen Plasmen aus. Sie eignen sich daher besonders als lichtempfindliche Resiste im kurzwelligen UV-Bereich ($\lambda < 300$ nm).

Die in den folgenden Beispielen genannten Teile und Prozente beziehen sich, soweit nicht anders angegeben, auf das Gewicht. Volumenteile verhalten sich zu Gewichtsteilen wie Liter zu Kilogramm.

Beispiel 1

Herstellen der Polymeren

14 teile o-Nitro-α-methylbenzylmethacrylat, 12 Teile Methacrylsäure und 37 Teile Methacrylnitril werden in 250 Vol.-Teilen Ethylacetat gelöst. Die Lösung wird 1 Stunde unter Stickstoff am Rückfluß erhitzt und dann werden 1,23 Teile Azo-bis-isobutyronitril zugegeben. Es wird weitere 8 Stunden am Rückfluß erhitzt und nach Abkühlung wird das Polymere in 2000 Vol.-Teilen Ligroin ausgefällt. Ausbeute: 17,4 Teile. Zur Fraktionierung wird das Polymere in 800 Vol.-Teilen Ethylacetat gelöst und bis zum Auftreten einer bleibenden Trübung werden 104 Vol.-Teile Ligroin zugetropft. Die Lösung wird dann erwärmt bis sie wieder klar wird, und schließlich läßt man abkühlen wobei sich eine ölige Phase abscheidet. Von der öligen Phase wird abdekantiert und in 800 Vol.-Teilen Ligroin gefällt. Das so fraktionierte Polymere hat ein Gewichtsmittel von 64.200 g/mol und eine Uneinheitlichkeit von 1.6. Titration mit KOH ergibt einen Gehalt an einpolymerisierter Methacrylsäure von 18,1 %. Aus UV-Messungen wird der o-Nitro-α-methylbenzylmethacrylatanteil zu 28 % bestimmt. Die Glastemperatur liegt bei 139°C.

Weitere Polymere werden analog dieser Vorschrift hergestellt.

Beispiel 2

Herstellen von Resiststrukturen

Eine Lösung von 25 Gew.% des in Beispiel 1 hergestellten Polymeren in Diethylenglykoldimethylether wird durch ein Filter (ca. 0,2 µm Porendurchmesser) filtriert. Etwa 2 ml dieser Lösung werden dann auf einen Siliziumwafer getropft. Der Wafer wird mit 2200 U/min geschleudert, wobei sich eine etwa 1 µm dicke Schicht ergibt. Nach dem Ausheizen für ca. 10 Minuten bei 140°C wird die lichtempfindliche Polymerschicht mit einem Excimer-Laser ($\lambda$ = 248 nm, KrF) durch eine strukturierte Maske belichtet. Als Kontaktmasse dient eine Quarzgraukeilmaske mit unterschiedlicher Transmission, womit eine Belichtung verschiedener Bereiche der lichtempfindlichen Schicht mit zunehmender Lichtmenge bewirkt wird. Die geringste Lichtmenge, die zu einem Abtrag der gesamten Schicht in den belichteten Bereichen führt, wird

als Empfindlichkeit der Lackschicht bezeichnet. Die Empfindlichkeit ist abhängig von der Entwicklerstärke und beträgt für eine 3 %ige wäßrige Triethanolaminlösung (mit 2 % Butylglykol) ca. 800 mJ/cm².

Unter diesen Bedingungen wird nun die lichtempfindliche Schicht über eine strukturierte Chrommaske innerhalb 25 Sekunden mit dem Laser belichtet, mit Triethanolaminlösung während 60 Sekungen entwickelt und anschließend getrocknet. Die so erzeugten Resiststrukturen dienen dann als Maske für die Übertragung des Resistmusters in $SiO_2$ mit Hilfe eines $SF_6$-Plasmas.

Beispiel 3

Plasmaätzbeständigkeit

Die Ätzexperimente wurden in einem handelsüblichen Parallelplattenreaktor der Firma Plasma-Technology durchgeführt. Der Reaktor besteht aus einem Vakuumsystem mit zwei darin parallel angeordneten Elektroden. Die zu ätzenden Substrate werden auf der unteren, wassergekühlten, geerdeten Elektrode positioniert. Zur Erzeugung des Plasmas wird die obere Elektrode an einen 13.56 MHz Hochfrequenzgenerator angeschlossen. Die Ätzungen wurden bei 50 Watt Generatorleistung und einem Gasdruck von 650 mTorr mit $SF_6$-Ätzgas durchgeführt. Die Temperatur der gekühlten Elektrode betrug während der Ätzung 25°C. Oxidierte Wafer wurden durch Spincoating einer Lösung der Polymeren in dem jeweils geeigneten Lösungsmittel mit einer 1 bis 2 µm dicken Schicht überzogen. Zur Entfernung des Restlösemittels wurden die Wafer 30 Minuten bei 160°C ausgeheizt. Jeweils vier Wafer wurden auf der unteren Elektrode positioniert, die Kammer evakuiert, Ätzgas eingeleitet und, nachdem sich der Druck stabilisiert hat, wird das Plasma gezündet. Die Schichtdicke vor und nach jedem Ätzzyklus wird mit einem handelsüblichen α-step Profilometer der Fa. Tencor Instruments gemessen. Als Vergleichssysteme wurden handelsüblicher Novolak-Resist sowie Polymethylmethacrylat und ein weiterer Acrylatresist, der anstelle von Methacylnitril Methylmethacrylat enthält, im gleichen Prozeß mitgeätzt. Die Ergebnisse sind in der Tabelle 1 aufgeführt.

Tabelle 1: Ätzrate von Polymeren im $SF_6$-Plasma

| Polymer | Ätzrate (Å/min) |
|---|---|
| Novolak-Positivresist | 236 |
| Poly-(oNMBMA$_{28}$-co-MAN$_{54}$-co-MAS$_{18}$)[a] (erfindungsgemäß) | 304 |
| Poly-(oNMBMA$_{19}$-co-MMA$_{67}$[b]-co-MAS$_{14}$) | 417 |
| Poly-(methyl-methacrylat) | 469 |

[a] oNMBMA = o-Nitro-α-methyl-benzylmethacrylat
MAN = Methacrylnitril
MAS = Methacrylsäure

[b] MMA = Methyl-methacrylat

## Ansprüche

1. Copolymerisate, die einpolymerisiert enthalten
(a) 5 bis 50 Mol.% mindestens einer Verbindung der allgemeinen Formel (I)

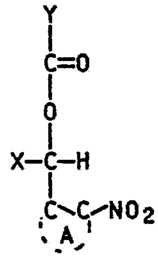

(I)

worin A für ein aromatisches oder heteroaromatisches, gegebenenfalls substituiertes Ringsystem mit 5 bis 14 Ringgliedern,
X für Wasserstoff, einen Alkylrest mit 1 bis 8 Kohlenstoffatomen, einen gegebenenfalls substituierten Aryl- oder Aralkylrest und
Y für einen ethylenisch ungesättigten Rest mit 2 bis 6 Kohlenstoffatomen stehen,
b) 94 bis 30 Mol.% Methacrylnitril
c) 1 bis 20 Mol.% mindestens einer olefinisch ungesättigten copolymerisierbaren Carbonsäure mit 3 bis 6 Kohlenstoffatomen,
d) 0 bis 30 Mol.% einer oder mehrerer weiterer von (a), (b) und (c) verschiedener olefinisch ungesättigter, copolymerisierbarer organischer Verbindungen, deren Homopolymerisate im Wellenlängenbereich zwischen 250 und 400 nm transparent sind,
mit der Maßgabe, daß die Summe der unter a) bis d) genannten Prozentzahlen 100 ist.

2. Copolymerisate nach Anspruch 1, dadurch gekennzeichnet, daß der Rest Y in der allgemeinen Formel (I) für einen der Reste

$-CH{=}CH_2$, 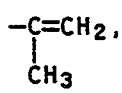, $-CH{=}CH{-}COOH$, $-CCl{=}CCl{-}COOH$, 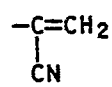, $-CH{=}CHCH_3$,

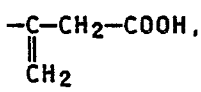, 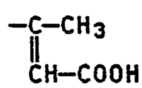 , 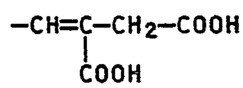 oder 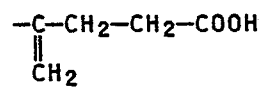

steht.

3. Copolymerisate nach Anspruch 1 oder 2, dadurch gekennzeichnet, daß in der allgemeinen Formel (I) der Rest A für Phenyl, der Rest X für Methyl und der Rest Y für eine

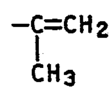

Gruppe steht.

4. Copolymerisate nach einem der Ansprüche 1 bis 3, dadurch gekennzeichnet, daß als Komponente (c) Methacrylsäure einpolymerisiert ist.

5. Verfahren zur Herstellung der Copolymerisate nach einem der Ansprüche 1 bis 4, dadurch gekennzeichnet, daß die unter (a) bis (d) genannten Verbindungen in Gegenwart radikalliefernder Initiatoren polymerisiert werden.

6. Wäßrig-alkalisch auswaschbare Photoresiste, dadurch gekennzeichnet, daß die Copolymerisate nach einem der Ansprüche 1 bis 4 enthalten.

7. Verfahren zur Herstellung von Halbleiterbauelementen, dadurch gekennzeichnet, daß man Copolymerisate nach einem der Ansprüche 1 bis 4 als lichtempfindliche Materialien verwendet.

8. Verwendung der Copolymerisate nach einem der Anprüche 1 bis 4 in lichtempfindlichen Beschichtungsmaterialien.

9. Verwendung der Copolymerisate nach einem der Ansprüche 1 bis 4 zur Herstellung von Trockenresisten.

10. Verwendung der Copolymerisate nach einem der Ansprüche 1 bis 4 für Flachdruckplatten.

11. Verwendung der Copolymerisate nach einem der Ansprüche 1 bis 4 als Photoätzgrund.

Patentansprüche für den folgenden Vertragsstaat:AT

1. Verfahren zur Herstellung von Copolymerisaten, dadurch gekennzeichnet, daß man
(a) 5 bis 50 Mol.% mindestens einer Verbindung der allgemeinen Formel (I)

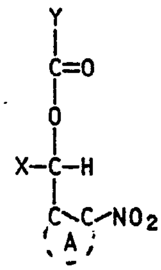

(I)

worin A für ein aromatisches oder heteroaromatisches, gegebenenfalls substituiertes Ringsystem mit 5 bis 14 Ringgliedern,
X für Wasserstoff, einen Alkylrest mit 1 bis 8 Kohlenstoffatomen, einen gegebenenfalls substituierten Aryl- oder Aralkylrest und
Y für einen ethylenisch ungesättigten Rest mit 2 bis 6 Kohlenstoffatomen stehen,
mit
b) 94 bis 30 Mol.% Methacrylnitril
c) 1 bis 20 Mol.% mindestens einer olefinisch ungesättigten copolymerisierbaren Carbonsäure mit 3 bis 6 Kohlenstoffatomen
und
d) 0 bis 30 Mol.% einer oder mehrerer weiterer von (a), (b) und (c) verschiedener olefinisch ungesättigter, copolymerisierbarer organischer Verbindungen, deren Homopolymerisate im Wellenlängenbereich zwischen 250 und 400 nm transparent sind,
mit der Maßgabe, daß die Summe der unter a) bis b) genannten Prozentzahlen 100 ist, copolymerisiert.

2. Verfahren nach Anspruch 1, dadurch gekennzeichnet, daß der Rest Y in der allgemeinen Formel (I) für einen der Reste

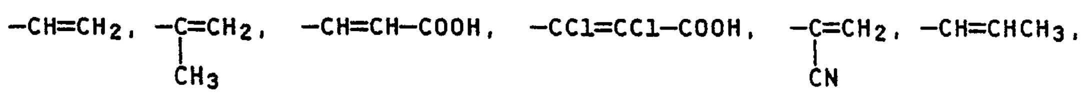

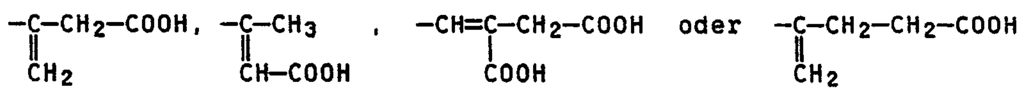

steht.

3. Verfahren nach Anspruch 1 oder 2, dadurch gekennzeichnet, daß in der allgemeinen Formel (I) der Rest A für Phenyl, der Rest X für Methyl und der Rest Y für eine

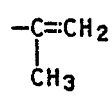

Gruppe steht.

4. Verfahren nach einem der Ansprüche 1 bis 3, dadurch gekennzeichnet, daß als Komponente (c) Methacrylsäure einpolymerisiert ist.

5. Verfahren zur Herstellung der Copolymerisate nach einem der Ansprüche 1 bis 4, dadurch gekennzeichnet, daß die unter (a) bis (d) genannten Verbindungen in Gegenwart radikalliefernder Initiatoren polymerisiert werden.

6. Verfahren zur Herstellung wäßrig-alkalisch auswaschbarer Photoresiste, dadurch gekennzeichnet, daß Copolymerisate, die nach einem Verfahren gemäß einem der Ansprüche 1 bis 5 erhalten wurden, eingesetzt werden.

7. Verfahren zur Herstellung von Halbleiterbauelementen, dadurch gekennzeichnet, daß man Copolymerisate, die nach einem Verfahren gemäß einem der Ansprüche 1 bis 5 herstellt wurden, als lichtemfindliche Materialien verwendet.

8. Verwendung der nach einem der Ansprüche 1 bis 5 hergestellten Copolymerisate in lichtempfindlichen Beschichtungsmaterialien.

9. Verwendung der nach einem der Ansprüche 1 bis 5 hergestellten Copolymerisate zur Herstellung von Trockenresisten.

10. Verwendung der nach einem der Ansprüche 1 bis 5 hergestellten Copolymerisate für Flachdruckplatten.

11. Verwendung der nach einem der Ansprüche 1 bis 5 hergestellten Copolymerisate als Photoätzgrund.